# EUROPEAN PATENT SPECIFICATION

(11) **EP 0 381 140 B1**
(45) Date of publication and mention of the grant of the patent: **22.06.1994**
(21) Application number: 90101808.5
(22) Date of filing: 30.01.1990
(51) Int. Cl.: G11C 29/00, G06F 9/44

(54) **Data processing apparatus**
Datenverarbeitungsgerät
Appareil de traitement de données

(30) Priority: 02.02.1989 JP 22631/89
(43) Date of publication of application: 08.08.1990
(73) Proprietor: NEC CORPORATION, Tokyo (JP)
(72) Inventor: Inoue, Kazuhisa, c/o Nec Corporation, Tokyo (JP)
(74) Representative: VOSSIUS & PARTNER

(56) References cited:
- PATENT ABSTRACTS OF JAPAN vol. 12, no. 93 (P-680)March 26, 1988& JP-A-62 226 216
- PATENT ABSTRACTS OF JAPAN vol. 8, no. 27 (P-252)(1464) February 4, 1984& JP-A-58 182 731
- PATENT ABSTRACTS OF JAPAN vol. 7, no. 266 (P-239)(1411) November 26, 1983;& JP-A-58147878

## Description

The present invention relates to a data processing apparatus, and more particularly, to initialization of a main storage.

In a conventional data processing apparatus of this type, the end of initialization of a main storage is determined by performing time monitoring by means of a diagnostic processor.

In the above-described data processing apparatus, the end of initialization of the main storage is determined by causing the diagnostic processor to monitor the lapse of the maximum time required to initialize the maximum storage capacity of the main storage by using a timer means. Therefore, even if the storage capacity of the main storage is changed, since the diagnostic processor can determine the end of initialization by monitoring only the lapse of the maximum time, the time for initialization is wasted.

JP-A-62 226 216 discloses a data processing apparatus in which the main storage is initialized.

A RAM circuit in which a clearing operation is finished in response to a counter reaching the final RAM address is known from JP-A-58 147 878.

It is a principal object of the present invention to provide a data processing apparatus which can eliminate the waste of time spent for initialization of a main storage.

In order to achieve the above object, according to the present invention, there is provided a data processing apparatus comprising an arithmetic processor, a system control unit, a main storage, and a diagnostic processor, the system control unit including a command code register, a store address register, and a store data register for respectively storing a command code, a store address, and store data, as store request data with respect to the main storage, supplied from the arithmetic processor, a request control section for controlling the command code register, the store address register, and the store data register in response to a store request, a count circuit for incrementing a content of the store address register under the control of the request control section, a capacity register for storing a storage capacity of the main storage, a comparator for comparing the content of the store address register with that of the capacity register so as to check whether a value of the store address register exceeds a value of the capacity register, an initialization flag to be set in response to a command for initializing the main storage from the diagnostic processor, a first AND circuit for disabling an output from the comparator to the arithmetic processor and a second AND circuit for enabling the output from the comparator to the diagnostic processor when the initialization flag is set, and a path for causing the request control section to perform a control operation for initialization of the main storage when the initialization flag is set, said diagnostic processor including a path for setting initialization data of the main storage in the command code register, the store address register, the store data register, and the initialization flag of the system control unit, wherein the data processing apparatus executes an initialization request from the diagnostic processor with respect to the main storage.

### Brief Description of the Drawing

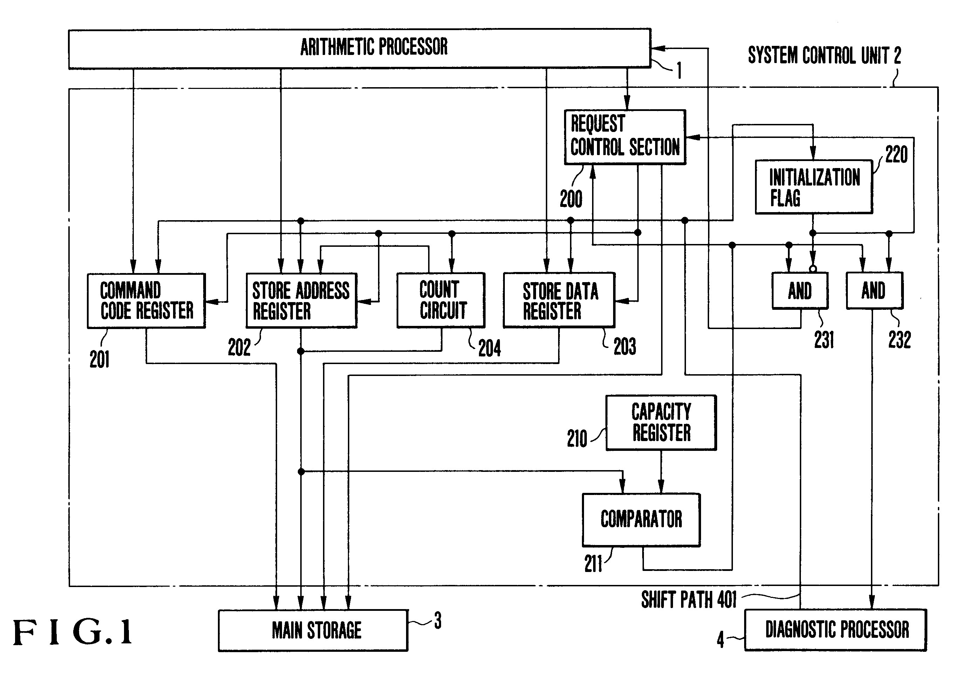

Fig. 1 is a block diagram showing an arrangement of a data processing apparatus according to an embodiment of the present invention.

### Detailed Description of the Preferred Embodiment

The present invention will be described below with reference to the accompanying drawing.

Referring to Fig. 1, a data processing apparatus according to an embodiment of the present invention includes an arithmetic processor 1, a system control unit 2, a main storage 3, and a diagnostic processor 4.

Registers 201 to 203 respectively serve as a command code register, a store address register, and a store data register. These registers respectively store a command code, a store address, and store data, as store request data with respect to the main storage 3, supplied from the arithmetic processor 1.

A request control section 200 controls the command code register 201, the store address register 202, and the store data register 203 in response to a store request sent to the arithmetic processor 1.

A count circuit 204 serves to increment the contents of the store address register 202.

A capacity register 210 is a register for storing the storage capacity of the main storage 3.

A comparator 211 compares the contents of the store address register 202 with those of the capacity register 210 so as to check whether an address value indicated by the store address register 202 exceeds the capacity indicated by the capacity register 210.

An initialization flag 220 is a flag to be set in response to a command for initializing the main storage 3 from the diagnostic processor 4.

AND circuits 231 and 232 are respectively used to disable an output from the comparator 211 to the arithmetic processor 1 and to enable the output from the comparator 211 to the diagnostic processor 4 when the initialization flag 220 is set.

In this case, if the diagnostic processor 4 receives an output, this indicates that the store address exceeds the capacity of the main storage 3. Thus, the diagnostic processor 4 can determine that initialization of the main storage 3 is completed.

In contrast to this, if the initialization flag 220 is not set, a response is supplied to the arithmetic processor 1 to cause it to recognize abnormality in the store address, and perform exception processing or the like.

A shift path 401 is a shift data path connected to the diagnostic processor 4. By performing a shift operation through the shift path 401, data can be set in the command code register 201, the store address register 202, the store data register 203, and the initialization flag 220.

A method of initializing the main storage 3 according to the present invention will be described below.

The diagnostic processor 4 sets, through the shift path 401, data required for the initialization of the main storage 3 in the command code register 201, the store address register 202, and the store data register 203, respectively, and sets the initialization flag 220.

When the initialization flag 220 is set, the request control section 200 keeps sending a store request to the main storage 3 while causing the count circuit 204 to increment the store address register 202 until the comparator determines that the store address exceeds the capacity of the main storage 3.

When the diagnostic processor 4 receives the output from the comparator 211, the processor 4 determines that the initialization of the main storage 3 is completed, and hence can execute the next processing.

As has been described above, according to the present invention, since the end of initialization of the main storage is determined on the basis of an output from the comparator to the diagnostic processor, the initialization end can be easily determined within a time corresponding to the capacity of the main storage, and the diagnostic processor can execute the next processing. Therefore, the waste of time spent for the initialization of the main storage can be eliminated.

## Claims

1. A data processing apparatus comprising an arithmetic processor, a system control unit, a main storage, and a diagnostic processor,
said system control unit including
a command code register, a store address register, and a store data register for respectively storing a command code, a store address, and store data, as store request data with respect to said main storage, supplied from said arithmetic processor,
a request control section for controlling said command code register, said store address register, and said store data register in response to a store request;
a count circuit for incrementing a content of said store address register under the control of said request control section,
a capacity register for storing a storage capacity of said main storage,
a comparator for comparing the content of said store address register with that of said capacity register so as to check whether a value of said store address register exceeds a value of said capacity register,
an initialization flag to be set in response to a command for initializing said main storage from said diagnostic processor,
a first AND circuit for disabling an output from said comparator to said arithmetic processor and a second AND circuit for enabling the output from said comparator to said diagnostic processor when said initialization flag is set, and
a path for causing said request control section to perform a control operation for initialization of said main storage when said initialization flag is set; and
said diagnostic processor including
a path for setting initialization data of said main storage in said command code register, said store address register, said store data register, and said initialization flag of said system control unit,
wherein said data processing apparatus executes an initialization request from said diagnostic processor with respect to said main storage.

## Patentansprüche

1. Datenverarbeitungsgerät mit einem Arithmetikprozessor, einer Systemsteuereinheit, einem Hauptspeicher und einem Diagnostikprozessor,
wobei die Systemsteuereinheit aufweist:
ein Befehlscoderegister, ein Speicheradreßregister und ein Speicherdatenregister zum Speichern eines Befehlscodes, einer Speicheradresse bzw. von Speicherdaten als Speicheranforderungsdaten für den Hauptspeicher, die von dem Arithmetikprozessor zugeführt werden,
einen Anforderungssteuerabschnitt zum Steuern des Befehlscoderegisters, des Speicheradreßregisters und des Speicherdatenregisters als Reaktion auf eine Speicheranforderung,
eine Zählschaltung zum Inkrementieren eines Inhalts des Speicheradreßregisters unter der Steuerung des Anforderungssteuerabschnitts,
ein Kapazitätsregister zum Speichern einer Speicherkapazität des Hauptspeichers,
einen Komparator zum Vergleichen des Inhalts des Speicheradreßregisters mit dem des Kapazitätsregisters, um zu prüfen, ob ein Wert des Speicheradreßregisters einen Wert des Kapazitätsregisters überschreitet,
ein Initialisierungsflag, das als Reaktion auf einen Befehl zum Initialisieren des Hauptspeichers von dem Diagnostikprozessor zu setzen ist,
eine erste UND-Schaltung zum Sperren einer Ausgabe von dem Komparator zu dem Arithmetikprozessor und eine zweite UND-Schaltung zum Freigeben der Ausgabe von dem Komparator zu dem Diagnostikprozessor, wenn das Initialisierungsflag gesetzt ist, und
einen Pfad zum Veranlassen, daß der Anforderungssteuerabschnitt eine Steueroperation zur Initialisierung des Hauptspeichers durchführt, wenn das Initialisierungsflag gesetzt ist, und
wobei der Diagnostikprozessor aufweist:
einen Pfad zum Setzen von Initialisierungsdaten des Hauptspeichers in dem Befehlscoderegister, dem Speicheradreßregister, dem Speicherdatenregister und dem Initialisierungsflag der Systemsteuereinheit,
wobei das Datenverarbeitungsgerät eine Initialisierungsanforderung von dem Diagnostikprozessor für den Hauptspeicher ausführt.

## Revendications

1. Appareil de traitement de données comprenant un processeur arithmétique, une unité de commande du système, une mémoire principale et un processeur de diagnostique,
ladite unité de commande du système comportant
un registre de codes d'ordres, un registre d'adresses de mémoire et un registre de données mémoire pour mémoriser respectivement un code d'ordre, une adresse de mémoire et des données de mémoire comme données de demande de mémoire par rapport à ladite mémoire principale délivrée à partir dudit processeur arithmétique,
une section de commande de demande pour commander ledit registre de codes d'ordres, ledit registre d'adresses de mémoire et ledit registre de données de mémoire en réponse à la demande de mémoire,
un circuit de comptage pour incrémenter un contenu dudit registre d'adresses de mémoire sous la commande de ladite section de commande de demande,
un registre de capacités pour mémoriser une capacité de mémoire de la mémoire principale,
un comparateur pour comparer le contenu dudit registre d'adresses de mémoire à celui dudit registre de capacités de façon à contrôler si une valeur dudit registre d'adresses de mémoire dépasse une valeur dudit registre de capacités,
un indicateur d'initialisation qui sera positionné en réponse à un ordre pour initialiser ladite mémoire principale à partir dudit processeur de diagnostique,
un premier circuit ET pour désactiver une sortie provenant dudit comparateur vers ledit processeur arithmétique et un second circuit ET pour activer la sortie provenant dudit comparateur vers ledit processeur de diagnostique lorsque ledit indicateur d'initialisation est positionné, et
un trajet pour amener ladite section de commande de demande à effectuer une opération de commande pour l'initialisation de ladite mémoire principale lorsque ledit indicateur d'initialisation est positionné, et
ledit processeur de diagnostique comportant
un trajet pour établir les données d'initialisation de ladite mémoire principale dans ledit registre de codes d'ordres, ledit registre d'adresses de mémoire, ledit registre de données de mémoire et pour établir l'indicateur d'initialisation de ladite unité de commande du système,
dans lequel ledit appareil de traitement de données exécute une demande d'initialisation provenant dudit processeur de diagnostique par rapport à ladite mémoire principale.
